# EUROPEAN PATENT APPLICATION

(11) **EP 4 030 490 A1**
(43) Date of publication of application: **20.07.2022**
(21) Application number: 20940304.7
(22) Date of filing: 12.06.2020
(51) Int. Cl.: H01L 29/78

(54) **SUPER-JUNCTION REVERSE-CONDUCTING INSULATED GATE BIPOLAR TRANSISTOR AND ELECTRIC VEHICLE MOTOR CONTROL UNIT**

(71) Applicant: Huawei Digital Power Technologies Co., Ltd., Shenzhen, Guangdong 518043 (CN)
(72) Inventor: HUANG, Boning, Shenzhen, Guangdong 518129 (CN); ZHANG, Quan, Shenzhen, Guangdong 518129 (CN); YANG, Wentao, Shenzhen, Guangdong 518129 (CN)
(74) Representative: Goddar, Heinz J.
(86) International application number: PCT/CN2020/095946
(87) International publication number: WO 2021/248494

(57) **Abstract**

This application provides a superjunction reverse conducting insulated gate bipolar transistor and an electric automobile motor control unit. The superjunction reverse conducting insulated gate bipolar transistor includes: an N-type buffer layer; a superjunction structure layer formed on a first principal surface of the N-type buffer layer, where the superjunction structure layer includes P-type drift regions and N-type drift regions that are alternately arranged in a first direction; a front-side component formed on the superjunction structure layer; a collector layer formed on a second principal surface of the N-type buffer layer, where the collector layer includes P+ collectors and N+ collectors that are alternately arranged in the first direction; and a collector electrode layer formed on the collector layer. In the superjunction structure layer, a region portion corresponding to the N+ collectors forms a first region and a region portion corresponding to the P+ collectors forms a second region, and in a second direction, a length of each drift region in the first region is not equal to a length of each drift region in the second region. This prolongs a time in which the motor control unit is in a MOSFET mode when working in a light load state, thereby improving conversion efficiency of the MCU.

## Description

### TECHNICAL FIELD

This application relates to the field of semiconductor technologies, and in particular, to a superjunction reverse conducting insulated gate bipolar transistor and an electric automobile motor control unit.

### BACKGROUND

As a core power electronic unit unique to an electric automobile, a motor control unit (motor control unit, MCU) controls, by receiving a vehicle traveling control instruction, a motor to output a specified torque and a specified rotational speed, to drive the vehicle to travel. During specific application, the MCU converts direct current energy of a power battery into a required high-voltage alternating current to drive the motor to output mechanical energy. Specifically, the MCU usually uses an insulated gate bipolar transistor (insulated gate bipolar transistor, IGBT) and a fast recovery diode (fast recovery diode, FRD) to form a switching element. The IGBT is a composite full-controlled voltage driven power semiconductor device made of a metal-oxide-semiconductor field-effect transistor (metal-oxide-semiconductor field-effect transistor, MOSFET) and a bipolar junction transistor (bipolar junction transistor, BJT). Based on this, the MCU has an advantage of high input impedance of the MOSFET and also has an advantage of a low conduction voltage drop of the BJT.

During working of the electric automobile MCU, there are three modes: an FRD mode, a MOSFET mode, and an IGBT mode. It is expected that the MCU works in the MOSFET mode as much as possible when the MCU works in a light load state, and that the MCU works in the IGBT mode more often when the MCU works in a full load state. Because the electric automobile MCU works in the light load state most of the time, it is expected that the MCU works in the MOSFET mode as much as possible, to improve conversion efficiency of the MCU.

### SUMMARY

This application provides a superjunction reverse conducting insulated gate bipolar transistor and an electric automobile motor control unit, to prolong a time in which the motor control unit is in a MOSFET mode when working in a light load state, thereby improving conversion efficiency of the MCU.

In one aspect, this application provides a superjunction reverse conducting insulated gate bipolar transistor. The superjunction reverse conducting insulated gate bipolar transistor includes: an N-type buffer layer, where one side of two opposite sides of the N-type buffer layer forms a first principal surface, and the other side of the two opposite sides forms a second principal surface; a superjunction structure layer and a front-side component of the superjunction reverse conducting insulated gate bipolar transistor that are formed on the first principal surface, and a collector layer and a collector electrode layer that are formed on the second principal surface. Specifically, in each structure layer on the first principal surface, the superjunction structure layer is formed on the first principal surface, and the superjunction structure layer includes a plurality of drift regions. The plurality of drift regions are classified into two types: P-type drift regions and N-type drift regions. The two types of drift regions are alternately arranged in a first direction in the superjunction structure layer. The first direction is perpendicular to a second direction formed in a direction in which the N-type buffer layer points to the superjunction structure layer. The front-side component of the superjunction reverse conducting insulated gate bipolar transistor is formed on one side that is of the superjunction structure layer and that faces away from the N-type buffer layer. Specifically, in a structure layer on the second principal surface, the collector layer is formed on the second principal surface. The collector layer specifically includes a plurality of P+ collectors and a plurality of N+ collectors that are alternately arranged in the first direction, and the collector electrode layer is formed on one side that is of the collector layer and that faces away from the second principal surface. It should be noted that in the superjunction reverse conducting insulated gate bipolar transistor, in the second direction, a portion that is corresponding to the N+ collectors and that is in the superjunction structure layer forms a first region and a portion that is corresponding to the P+ collectors and that is in the superjunction structure layer forms a second region, and a length of each drift region in the first region is not equal to a length of each drift region in the second region.

In the superjunction reverse conducting insulated gate bipolar transistor, the length of the drift region in the first region in the second direction is not equal to the length of the drift region in the second region in the second direction, and a relative relationship between the length of each drift region in the first region of the superjunction structure layer in the second direction and the length of each drift region in the second region of the superjunction structure layer in the second direction may be flexibly adjusted, to control an MCU to be in a MOSFET mode more often when the MCU is in a light load state. This increases duration of the MCU in the MOSFET mode when working in the light load state, thereby improving conversion efficiency of the MCU and prolonging a service life of a battery.

When a structure of the front-side component is specifically disposed, the front-side component may include an N-drift layer, a P-base layer, N-type emitter layers, P+ contact layers, a gate electrode, and an emitter electrode. Specifically, the N-drift layer is formed on the superjunction structure layer. The P-base layer is formed on the N-drift layer. The N-type emitter layers and the P+ contact layers are formed on a surface of the P-base layer. The N-type emitter layers and the P+ contact layers are also alternately arranged in the first direction. The gate electrode penetrates from surfaces of the N-type emitter layers to the N-drift layer, and a gate oxide layer is formed on a surface layer of the gate electrode. The emitter electrode is formed on the N-type emitter layers, the emitter electrode is electrically connected to the N-type emitter layers, and the emitter electrode is insulated from the gate electrode. In the foregoing structure, the N+ collectors, the N-type buffer layer, the N-type drift regions of the superjunction structure layer in the first region, the N-drift layer, and the P-base layer form an FRD. It should be noted that, to reduce an electrical level, a portion of the superjunction structure layer in the first region and/or a portion of the superjunction structure layer in the second region may be electrically connected to the emitter electrode.

That in the superjunction structure layer, a length of each drift region in the first region in the second direction is not equal to a length of each drift region in the second region in the second direction may be implemented in the following implementations. The implementations are specifically as follows:

Implementation 1: In the second direction, a thickness of the superjunction structure layer in the first region is not equal to a thickness of the superjunction structure layer in the second region, and superjunction structure layers in the first region are continuous in the second direction and superjunction structure layers in the second region are continuous in the second direction. In a specific implementation, in the second direction, the thickness of the superjunction structure layer in the first region is greater than the thickness of the superjunction structure layer in the second region. In another specific implementation, in the second direction, the thickness of the superjunction structure layer in the second region is greater than the thickness of the superjunction structure layer in the first region. It should be understood that in the two specific implementations, that the length of each drift region in the first region in the second direction is not equal to the length of each drift region in the second region in the second direction is implemented by changing the thicknesses of the superjunction structure layer in the first region and the second region.

Implementation 2: In the second direction, a thickness of the superjunction structure layer in the first region is equal to a thickness of the superjunction structure layer in the second region. In other words, the superjunction structure layer is even in thickness in the second direction. It should be understood that in the second direction, segmented regions may be disposed in the drift regions in the first region and/or the drift regions in the second region. To be specific, that in the superjunction structure layer, the length of each drift region in the first region in the second direction is not equal to the length of each drift region in the second region in the second direction is implemented by disposing the segmented regions.

Specifically, the length of the drift region in the first region and the length of the drift region in the second region may be adjusted by setting lengths of the segmented regions in the second direction. Specific implementations are as follows:

Specific implementation 1: Each drift region in the first region or each drift region in the second region has a segmented region in the second direction, and the segmented regions of the drift regions are continuous in the first direction.

Specific implementation 2: Each drift region in the first region or each drift region in the second region has a segmented region in the second direction, and the segmented regions of the drift regions are discontinuous in the first direction.

It should be understood that, in the implementation 1 and the implementation 2, segmented regions may be disposed in the drift regions in the first region, or segmented regions may be disposed in the drift regions in the second region. Certainly, segmented regions may alternatively be disposed both in the drift regions in the first region and the drift regions in the second region. The segmented regions of the drift regions in the first region may be continuous or discontinuous in the first direction. Likewise, the segmented regions of the drift regions in the second region may be continuous or discontinuous in the first direction. Based on this, the following specific implementations are formed.

Specific implementation 3: In the first region, each drift region has a segmented region in the second direction, and the segmented regions of the drift regions are continuous in the first direction; and in the second region, each drift region also has a segmented region in the second direction, and the segmented regions of the drift regions are continuous in the first direction. However, a length of the segmented region of each drift region in the first region in the second direction is not equal to a length of the segmented region of each drift region in the second region in the second direction.

Specific implementation 4: In the first region, each drift region has a segmented region in the second direction, and the segmented regions of the drift regions are discontinuous in the first direction; and in the second region, each drift region also has a segmented region in the second direction, and the segmented regions of the drift regions are discontinuous in the first direction. However, a length of the segmented region of each drift region in the first region in the second direction is not equal to a length of the segmented region of each drift region in the second region in the second direction.

Specific implementation 5: In the first region, each drift region has a segmented region in the second direction, and the segmented regions of the drift regions are continuous in the first direction; and in the second region, each drift region also has a segmented region in the second direction, and the segmented regions of the drift regions are discontinuous in the first direction. However, a length of the segmented region of each drift region in the first region in the second direction is not equal to a length of the segmented region of each drift region in the second region in the second direction.

Specific implementation 6: In the first region, each drift region has a segmented region in the second direction, and the segmented regions of the drift regions are discontinuous in the first direction; and in the second region, each drift region also has a segmented region in the second direction, and the segmented regions of the drift regions are continuous in the first direction. However, a length of the segmented region of each drift region in the first region in the second direction is not equal to a length of the segmented region of each drift region in the second region in the second direction.

In the specific implementation 1 to the specific implementation 6, the relative relationship between the length of the drift region in the first region in the second direction and the length of the drift region in the second region in the second direction is flexibly adjusted by disposing the segmented regions in the superjunction structure layer. It should be noted that, for the superjunction reverse conducting insulated gate bipolar transistor, by controlling the lengths of the drift regions in the first region and the second region, the MCU can be flexibly controlled to be in the MOSFET mode more often when working in the light load state, thereby improving the conversion efficiency of the MCU and prolonging the service life of the battery.

In another aspect, this application further provides an electric automobile motor control unit. The electric automobile motor control unit includes a superjunction reverse conducting insulated gate bipolar transistor. The superjunction reverse conducting insulated gate bipolar transistor is any one of the superjunction reverse conducting insulated gate bipolar transistors in the foregoing technical solutions. During working of the electric automobile MCU, there are three modes: an FRD mode, a MOSFET mode, and an IGBT mode. For the superjunction reverse conducting insulated gate bipolar transistor used as a switch of the MCU, in an internal superjunction structure layer, a length that is in the second direction and that is of each drift region in the first region corresponding to N+ collectors and a length that is in the second direction and that is of each drift region in the second region corresponding to P+ collectors are flexibly adjusted. This can prolong duration of the MCU in the MOSFET mode when working in a light load state, thereby improving conversion efficiency of the MCU.

### BRIEF DESCRIPTION OF DRAWINGS

FIG. 1 is a schematic structural diagram of a cross section of a superjunction reverse conducting insulated gate bipolar transistor according to an embodiment of the present invention;
FIG. 2 is a schematic structural diagram of another cross section of a superjunction reverse conducting insulated gate bipolar transistor according to an embodiment of the present invention;
FIG. 3 is a schematic structural diagram of another cross section of a superjunction reverse conducting insulated gate bipolar transistor according to an embodiment of the present invention;
FIG. 4 is a schematic structural diagram of another cross section of a superjunction reverse conducting insulated gate bipolar transistor according to an embodiment of the present invention;
FIG. 5 is a schematic structural diagram of another cross section of a superjunction reverse conducting insulated gate bipolar transistor according to an embodiment of the present invention;
FIG. 6 is a schematic structural diagram of another cross section of a superjunction reverse conducting insulated gate bipolar transistor according to an embodiment of the present invention;
FIG. 7 is a schematic structural diagram of another cross section of a superjunction reverse conducting insulated gate bipolar transistor according to an embodiment of the present invention;
FIG. 8 is a schematic structural diagram of another cross section of a superjunction reverse conducting insulated gate bipolar transistor according to an embodiment of the present invention; and
FIG. 9 is a schematic diagram of a three-dimensional structure of a superjunction reverse conducting insulated gate bipolar transistor according to an embodiment of the present invention.

Reference numerals: 10: N-type buffer layer; 20: superjunction structure layer; 201: P-type drift region; 202: N-type drift region; 30: N-drift layer; 40: P-base layer; 50: N-type emitter layer; 60: P+ contact layer; 70: gate electrode; 80: gate oxide layer; 90: emitter electrode; 100: collector layer; 1001: P+ collector; 1002: N+ collector; 110: collector electrode layer; and 120: through hole.

### DESCRIPTION OF EMBODIMENTS

The following clearly and completely describes technical solutions in embodiments of this application with reference to the accompanying drawings in the embodiments of this application.

An application scenario of this application is first described. In recent years, electric automobiles gradually emerge due to social needs for new energy. As a switching element of an electric automobile, an MCU converts a direct current output by a battery in the electric automobile into an alternating current during use of the MCU, to drive a motor. For a structure of the MCU, an IGBT and an FRD are usually used together in the conventional technology, so that during working of the electric automobile MCU, there are three modes: an FRD mode, a MOSFET mode, and an IGBT mode. When the MCU is in a light load state, the MCU is either in the MOSFET mode or in the IGBT mode for some time. Comparatively, in the conventional technology, the MCU is in the light load state for a relatively long time, and if the MCU works in the MOSFET mode when the MCU is in the light load state, conversion efficiency of the MCU can be improved. However, in the conventional technology, the MCU works in the MOSFET mode for a relatively short time when the MCU is in the light load state. This causes relatively low conversion efficiency of the MCU.

Based on the foregoing application scenario, an embodiment of this application provides a superjunction reverse conducting insulated gate bipolar transistor, to prolong a time in which a motor control unit is in a MOSFET mode when working in a light load state, thereby improving conversion efficiency of the MCU.

Terms used in the following embodiments are merely intended to describe specific embodiments, but are not intended to limit this application. Terms "one", "a", "the", "the foregoing", "this", and "the one" of singular forms used in this specification and the appended claims of this application are also intended to include plural forms such as "one or more", unless otherwise specified in the context clearly.

Reference to "an embodiment", "some embodiments", or the like described in this specification indicates that one or more embodiments of this application include a specific feature, structure, or characteristic described with reference to the embodiments. Therefore, in this specification, statements, such as "in an embodiment", "in some embodiments", "in some other embodiments", and "in other embodiments", that appear at different places do not necessarily mean referring to a same embodiment. Instead, the statements mean "one or more but not all of the embodiments", unless otherwise specifically emphasized in another manner. The terms "include", "comprise", "have", and variants of the terms all mean "include but are not limited to", unless otherwise specifically emphasized in another manner.

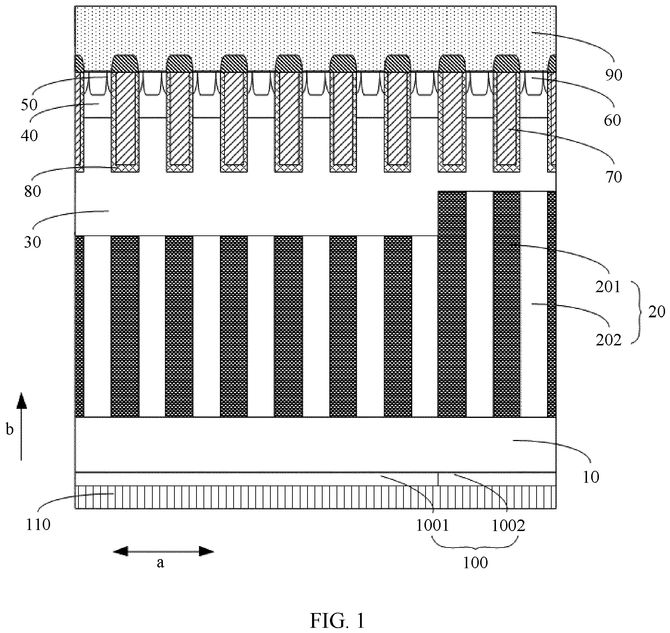

An embodiment of this application provides a superjunction reverse conducting insulated gate bipolar transistor. The superjunction reverse conducting insulated gate bipolar transistor includes an N-type buffer layer 10 shown in FIG. 1, one side of the N-type buffer layer 10 is a first principal surface, and the other side of the N-type buffer layer 10 is a second principal surface. A superjunction structure layer 20 is formed on the first principal surface of the N-type buffer layer 10, and the superjunction structure layer 20 includes a plurality of drift regions. Specifically, some of the plurality of drift regions are P-type drift regions 201 and the other some of the plurality of drift regions are N-type drift regions 202, and the P-type drift regions 201 and the N-type drift regions 202 are alternately arranged in a first direction a. It should be noted that the first direction a herein is perpendicular to a second direction b formed in a direction in which the N-type buffer layer 10 points to the superjunction structure layer 20. A front-side component of the superjunction reverse conducting insulated gate bipolar transistor is formed on the superjunction structure layer 20.

It should be noted that there are a plurality of possibilities for a structure of the front-side component, and an optional structure of the front-side component is provided herein. For details about the structure of the front-side component, still refer to a structure shown in FIG. 1. The front-side component includes an N-drift layer 30 formed on the superjunction structure layer 20, a P-base layer 40 formed on the N-drift layer 30, and N-type emitter layers 50 and P+ contact layers 60 that are formed on a surface of the P-base layer 40, where the N-type emitter layers 50 and the P+ contact layers 60 are also alternately arranged in the first direction a. In addition, the front-side component further includes a gate electrode 70. The gate electrode 70 penetrates from surfaces of the N-type emitter layers 50 to the N-drift layer 30, and a gate oxide layer 80 is formed on a surface layer of the gate electrode 70. The front-side component further includes an emitter electrode 90 formed on the N-type emitter layers 50. The emitter electrode 90 is electrically connected to the N-type emitter layers 50, and the emitter electrode 90 is insulated from the gate electrode 70.

Still refer to the structure shown in FIG. 1. A collector layer 100 is formed on the second principal surface of the N-type buffer layer 10. The collector layer 100 specifically includes a plurality of P+ collectors 1001 and a plurality of N+ collectors 1002. Specifically, the P+ collectors 1001 and the N+ collectors 1002 are also alternately arranged in the first direction a. Still refer to the structure shown in FIG. 1. A collector electrode layer 110 is formed on the collector layer 100.

It should be understood that in the superjunction reverse conducting insulated gate bipolar transistor, the N+ collectors 1002, the N-type buffer layer 10, the N-type drift regions 202 of the superjunction structure layer 20 in a region corresponding to the N+ collectors 1002, the N-drift layer 30, and the P-base layer 40 form an FRD.

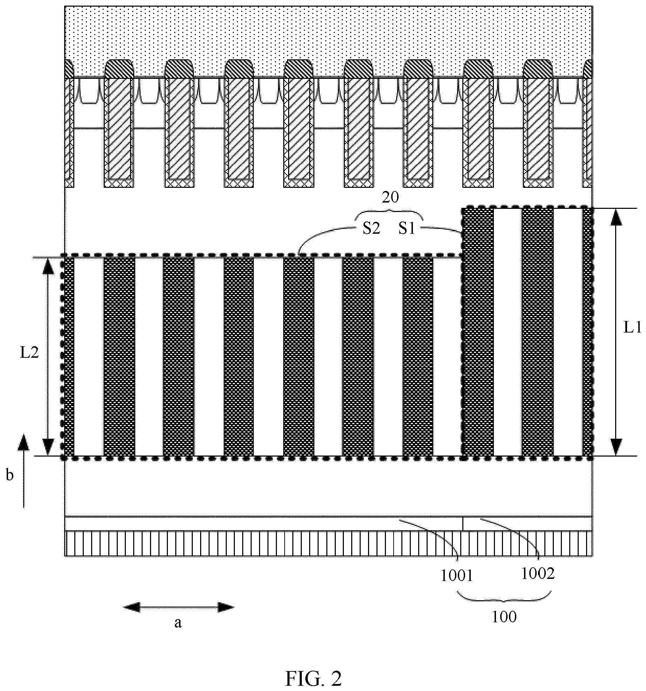

For ease of more intuitive description, in a structure shown in FIG. 2, an example in which the P+ collector 1001 and the N+ collector 1002 that are adjacent to each other form one collector unit is used. It should be understood that, the collector layer 100 in the superjunction reverse conducting insulated gate bipolar transistor provided in this embodiment of this application includes a plurality of collector units arranged in the first direction a, which are not shown in FIG. 2. In addition, when the collector layer 100 includes the plurality of collector units arranged in the first direction a, a first region S1 corresponding to the N+ collectors 1002 and a second region S2 corresponding to the P+ collectors 1001 in the superjunction structure layer 20 are not limited to the structure in FIG. 2.

The structure shown in FIG. 2 is detailed herein. In a region that is corresponding to the collector unit and that is in the superjunction structure layer 20, a portion corresponding to the N+ collectors 1002 forms the first region S1 and a portion corresponding to the P+ collectors 1001 forms the second region S2. In the second direction b, a thickness of the superjunction structure layer 20 in the first region S1 is L1 and a thickness of the superjunction structure layer 20 in the second region S2 is L2. Because drift regions in the first region S1 are continuous in the second direction b and drift regions in the second region S2 are continuous in the second direction b, the thickness L1 of the superjunction structure layer 20 in the first region S1 is a length of each drift region in the region in the second direction b, and likewise, the thickness L2 of the superjunction structure layer 20 in the second region S2 is a length of each drift region in the region in the second direction b. It can be learned from the structure shown in FIG. 2 that the length L1 of each drift region in the first region S1 is not equal to the length L2 of each drift region in the second region S2.

Specifically, a manner 1 is formed by using the structure shown in FIG. 2. In the manner 1, the thickness of the superjunction structure layer 20 in the first region S1 is greater than the thickness of the superjunction structure layer in the second region S2. For the first region S1, the drift regions in the first region S1 are continuous in the second direction b, that is, each drift region has no segmented region in the second direction b. Likewise, for the second region S2, the drift regions in the second region S2 are continuous in the second direction b, that is, each drift region has no segmented region in the second direction b. This means that in the structure in the manner 1, the lengths of each drift region in the first region S1 and each drift region in the second region S2 in the second direction b are adjusted by changing the film thicknesses of the first region S1 and the second region S2 in the second direction b.

It should be understood that, when the length of each drift region in the first region S1 in the second direction b is not equal to the length of each drift region in the second region S2 in the second direction b, a relative relationship between the length of each drift region in the first region S1 in the second direction b and the length of each drift region in the second region S2 in the second direction b may be adjusted, to flexibly control a time of an MCU in each mode when the MCU is in a light load state. This prolongs a time in which the MCU is in a MOSFET mode when the MCU is in the light load state, thereby improving conversion efficiency of the MCU.

A manner 2 is formed based on the manner 1, and the manner 2 is different from the manner 1 only in that, in the second direction b, the thickness of the superjunction structure layer 20 in the first region S1 is less than the thickness of the superjunction structure layer in the second region S2. In other words, the length of each drift region in the first region S1 in the second direction b is less than the length of each drift region in the second region S2 in the second direction b. In addition, the difference between the manner 1 and the manner 2 only lies in a change in the film thicknesses of the first region S1 and the second region S2 in the second direction b, and therefore the manner 2 is not shown in the accompanying drawings.

Certainly, in the manner 1, the thickness of the superjunction structure layer 20 in the first region S1 in the second direction b may alternatively be set to be equal to the thickness of the superjunction structure layer 20 in the second region S2 in the second direction b. Specifically, the length of each drift region in the first region S1 in the second direction b and the length of each drift region in the second region S2 in the second direction b are adjusted to be not equal by using a method for disposing segmented regions in each drift region in the first region S1 and/or in each drift region in the second region S2.

It should be noted that, by changing disposing locations and setting quantities of segmented regions, the following manners are at least formed.

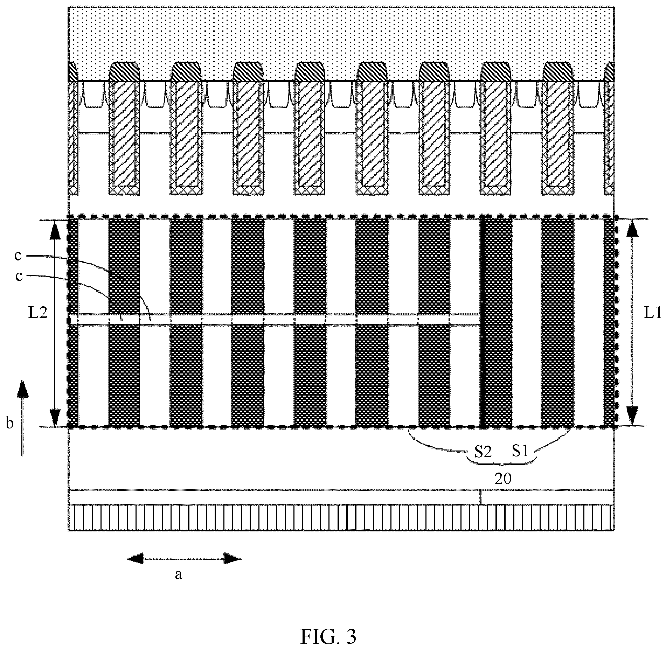

Refer to a manner 3 in FIG. 3. In the second direction b, a thickness L1 of the superjunction structure layer 20 in the first region S1 is equal to a thickness L2 of the superjunction structure layer 20 in the second region S2. In addition, drift regions in the second region S2 are discontinuous in the second direction b. Specifically, each drift region in the second region S2 has a segmented region c in the second direction b, and the segmented regions of the drift regions are continuous in the first direction a. It should be understood that, for ease of highlighting the segmented regions c, dashed lines are used for separation in FIG. 3.

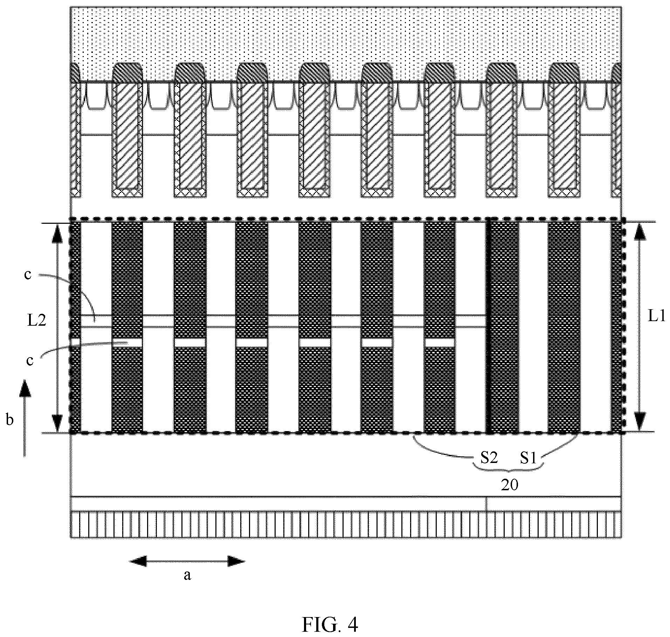

A manner 4 is formed based on the manner 3. In a structure shown in FIG. 4, the manner 4 is different from the manner 3 only in that, the segmented regions c of the drift regions in the second region S2 are discontinuous in the first direction a. All other structures are the same as those in the manner 3, and details are not described herein again.

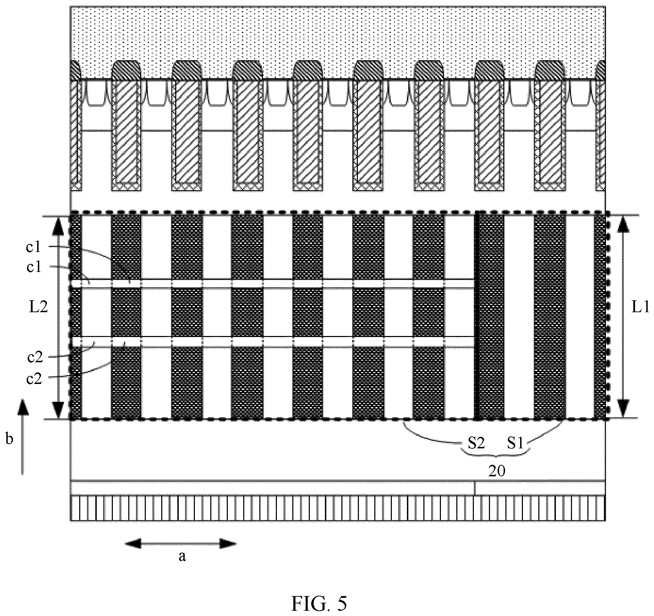

A manner 5 is formed based on the manner 3. In a structure shown in FIG. 5, the manner 5 is different from the manner 3 only in that, two segmented regions, that is, a segmented region c1 and a segmented region c2 in FIG. 5, are disposed in each drift region in the second region S2. In addition, the segmented regions c1 of the drift regions are continuous in the first direction a, and the segmented regions c2 of the drift regions are also continuous in the first direction a. All other structures are the same as those in the manner 3, and details are not described herein again. It should be understood that there may be at least two segmented regions in each drift region in the second region S2, and details are not described herein.

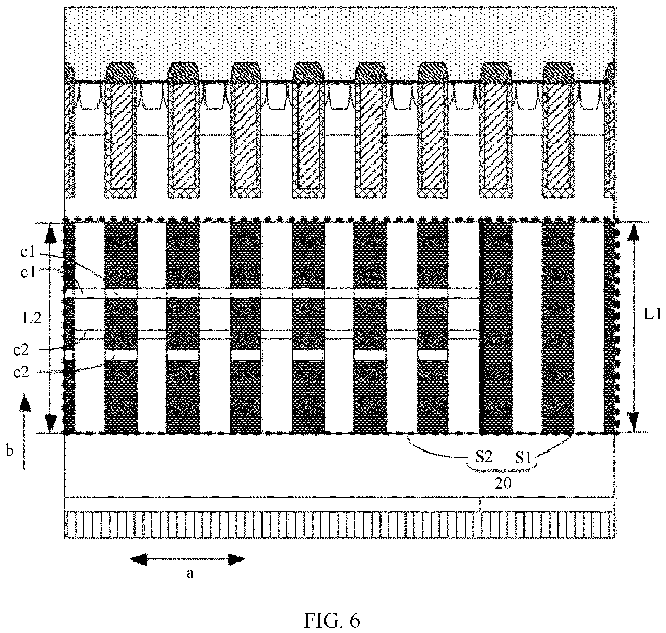

A manner 6 is formed based on the manner 5. In a structure shown in FIG. 6, each drift region in the second region S2 has two segmented regions, that is, a segmented region c1 and a segmented region c2 in FIG. 6. Still refer to FIG. 6. The manner 6 is different from the manner 5 only in that, the segmented region c1 of the drift region in the second region S2 are continuous in the first direction a, and a segmented region c2 of each drift region in the second region S2 and segmented regions c2 of other drift regions in the second region S2 are discontinuous in the first direction a. All other structures are the same as those in the manner 5, and details are not described herein again.

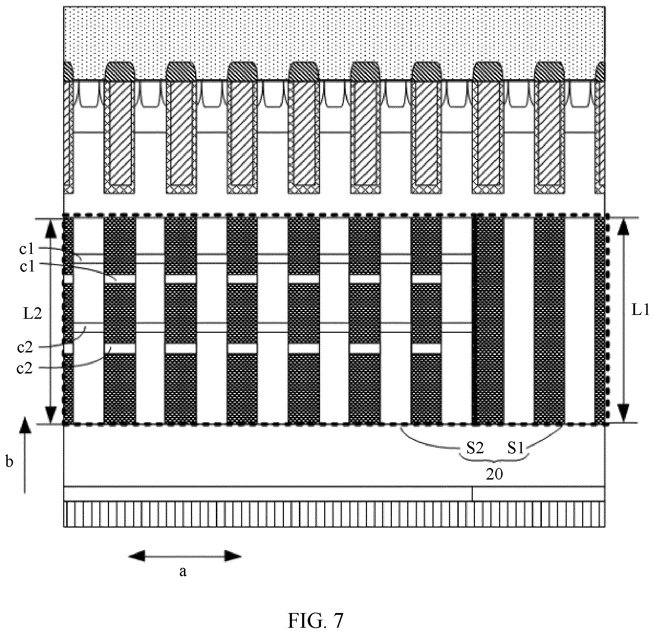

A manner 7 is formed based on the manner 5. In a structure shown in FIG. 7, each drift region in the second region S2 has two segmented regions, that is, a segmented region c1 and a segmented region c2 in FIG. 6. Still refer to FIG. 7. The manner 7 is different from the manner 5 only in that, a segmented region c1 of each drift region in the second region S2 and segmented regions c1 of other drift regions in the second region S2 are discontinuous in the first direction a, and a segmented region c2 of each drift region in the second region S2 and segmented regions c2 of other drift regions in the second region S2 are discontinuous in the first direction a. All other structures are the same as those in the manner 5, and details are not described herein again.

It should be noted that, in all of the foregoing manner 3, manner 4, manner 5, manner 6, and manner 7, segmented regions are disposed in the second region S2. It should be understood that the segmented regions may be disposed in the first region S1, and no segmented region is disposed in the second region S2. Based on this, a manner 8 is formed based on the manner 3, a manner 9 is formed based on the manner 4, a manner 10 is formed based on the manner 5, a manner 11 is formed based on the manner 6, and a manner 12 is formed based on the manner 7. Details are as follows:

The manner 8 is formed based on the manner 3, and the manner 8 is different from the manner 3 only in that, the segmented regions are disposed in the first region S1, and the drift regions in the second region S2 are continuous in the second direction b. All other structures in the manner 8 are the same as those in the manner 3, and therefore the manner 8 is not shown in the accompanying drawings.

The manner 9 is formed based on the manner 4, and the manner 9 is different from the manner 4 only in that, the segmented regions are disposed in the first region S1, and the drift regions in the second region S2 are continuous in the second direction b. All other structures in the manner 9 are the same as those in the manner 4, and therefore the manner 9 is not shown in the accompanying drawings.

The manner 10 is formed based on the manner 5, and the manner 10 is different from the manner 5 only in that, the segmented regions are disposed in the first region S1, and the drift regions in the second region S2 are continuous in the second direction b. All other structures in the manner 10 are the same as those in the manner 5, and therefore the manner 10 is not shown in the accompanying drawings.

The manner 11 is formed based on the manner 6, and the manner 11 is different from the manner 6 only in that, the segmented regions are disposed in the first region S1, and the drift regions in the second region S2 are continuous in the second direction b. All other structures in the manner 11 are the same as those in the manner 6, and therefore the manner 11 is not shown in the accompanying drawings.

The manner 12 is formed based on the manner 7, and the manner 12 is different from the manner 7 only in that, the segmented regions are disposed in the first region S1, and the drift regions in the second region S2 are continuous in the second direction b. All other structures in the manner 12 are the same as those in the manner 7, and therefore the manner 12 is not shown in the accompanying drawings.

It should be understood that, when a segmented region is disposed in each drift region in the first region S1, a segmented region may also be disposed in each drift region in the second region S2. Specifically, the manner 3, manner 4, manner 5, manner 6, and manner 7 formed by disposing segmented regions only in the second region S2 may be arbitrarily combined with the manner 8, manner 9, manner 10, manner 11, and manner 12 formed by disposing segmented regions only in the first region S1. During combination, it is only required that the length of each drift region in the first region S1 in the second direction b should not be equal to the length of each drift region in the second region S2 in the second direction b.

An example is used for description in which the solutions in the manner 3 and the manner 8 are combined to form a manner 13, and the other combination manners are not described herein. A specific structure in the manner 13 is as follows:

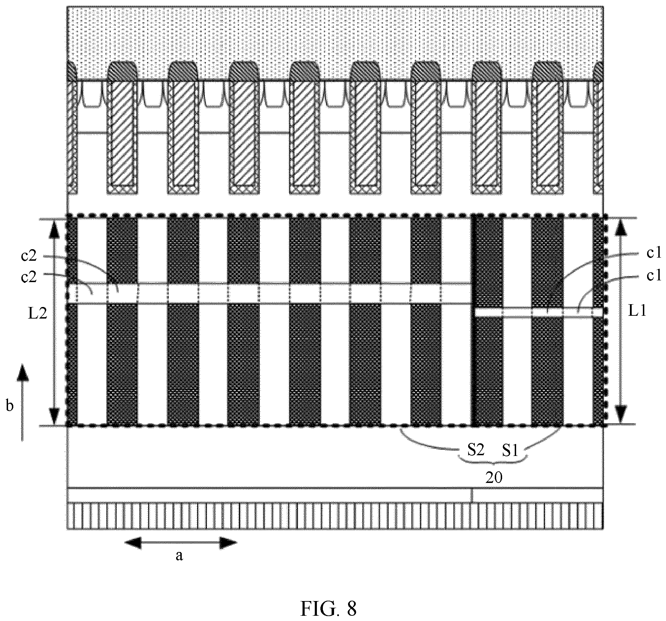

The manner 13 is formed based on the manner 3 and the manner 8. Refer to a structure shown in FIG. 8. In the manner 13, each drift region in the first region S1 has a segmented region c1 in the second direction b, and the segmented regions c1 of the drift regions in the first region S1 are continuous in the first direction a. In addition, each drift region in the second region S2 has a segmented region c2 in the second direction b, and the segmented regions c2 of the drift regions in the second region S2 are continuous in the first direction a. In the manner 13, by adjusting lengths of the segmented regions c1 and the segmented regions c2 in the second direction b, that the length of each drift region in the first region S1 in the second direction b is not equal to the length of each drift region in the second region S2 in the second direction b may be controlled, and a relative relationship between the length of each drift region in the first region S1 and the length of each drift region in the second region S2 may be adjusted, to flexibly control a time of an MCU in each mode when the MCU is in a light load state. This prolongs a time in which the MCU is in a MOSFET mode when the MCU is in the light load state, thereby improving conversion efficiency of the MCU.

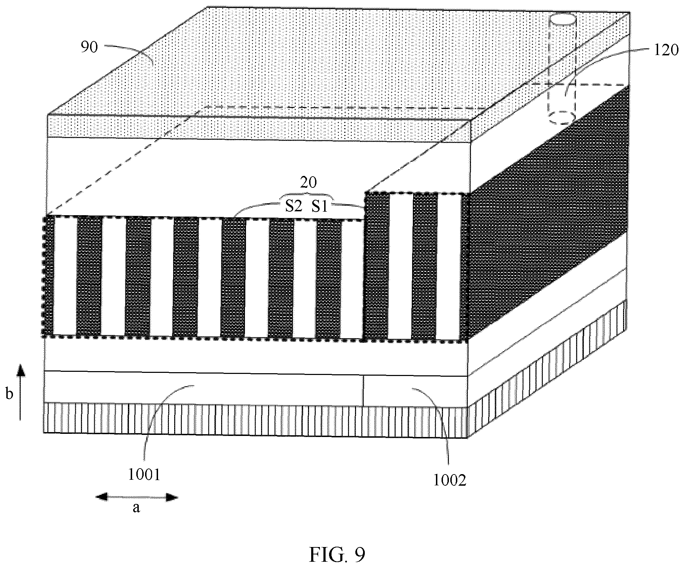

Moreover, to reduce an electrical level, the drift regions in the first region S1 corresponding to the N+ collectors 1002 in the superjunction structure layer 20 in the manner 1 shown in FIG. 2 may further be electrically connected to the emitter electrode 90 through a conducting material filled in a through hole 120, to form a structure shown in FIG. 9. It should be understood that the structure in FIG. 9 is merely for illustrative description, and a specific connection manner between the drift region in the first region S1 and the emitter electrode 90 is not limited thereto. It should be understood that, in the structure in FIG. 9, the electrical level of the superjunction structure layer 20 is reduced on a premise of adjusting a length relationship between the length of each drift region in the first region S1 and the length of each drift region in the second region S2, to flexibly control a time of an MCU in each mode when the MCU is in a light load state. This prolongs a time in which the MCU is in a MOSFET mode when the MCU is in the light load state, thereby improving conversion efficiency of the MCU. Certainly, the drift regions in the second region S2 corresponding to the P+ collectors 1001 in the superjunction structure layer 20 in the manner 1 may alternatively be electrically connected to the emitter electrode 90, or both portions of the superjunction structure layer 20 in the first region S1 and the second region S2 may be electrically connected to the emitter electrode 90. The two connection manners are equivalent to changing disposing locations and setting quantities of through holes 120 in FIG. 9, and therefore the connection manners are not shown in the accompanying drawings.

It should be understood that, in the foregoing solution, only an example is used for description in which the drift regions in the first region S1 in the superjunction structure layer 20 in the manner 1 are electrically connected to the emitter electrode 90. Certainly, the superjunction structure layer 20 in the foregoing manner 2 to manner 13 may alternatively be electrically connected to the emitter electrode 90 to reduce the electrical level. Electrical connection structures in the manners are the same as that in FIG. 9, and therefore the electrical connection structures herein are not shown in the accompanying drawings.

In another aspect, this application further provides an electric automobile motor control unit. The electric automobile motor control unit includes a superjunction reverse conducting insulated gate bipolar transistor. The superjunction reverse conducting insulated gate bipolar transistor is any one of the superjunction reverse conducting insulated gate bipolar transistors in the foregoing technical solutions. During working of the electric automobile MCU, there are three modes: an FRD mode, a MOSFET mode, and an IGBT mode. For the superjunction reverse conducting insulated gate bipolar transistor used as a switch of the MCU, in the internal superjunction structure layer 20 shown in FIG. 2, the length that is in the second direction b and that is of each drift region in the first region S1 corresponding to the N+ collectors 1002 and the length that is in the second direction b and that is of each drift region in the second region S2 corresponding to the P+ collectors 1001 are flexibly adjusted. This can prolong duration of the MCU in the MOSFET mode when working in a light load state, thereby improving conversion efficiency of the MCU.

Obviously, a person skilled in the art can make various modifications and variations to the embodiments of this application without departing from the spirit and scope of the embodiments of this application. This application is intended to cover these modifications and variations of the embodiments of this application provided that they fall within the scope of protection defined by the following claims and their equivalent technologies.

## Claims

1. A superjunction reverse conducting insulated gate bipolar transistor, comprising:
an N-type buffer layer;
a superjunction structure layer formed on a first principal surface of the N-type buffer layer, wherein the superjunction structure layer comprises a plurality of drift regions, some of the plurality of drift regions are P-type drift regions and the other some of the plurality of drift regions are N-type drift regions, the P-type drift regions and the N-type drift regions are alternately arranged in a first direction, and the first direction is perpendicular to a second direction formed in a direction in which the N-type buffer layer points to the superjunction structure layer;
a front-side component that is of the superjunction reverse conducting insulated gate bipolar transistor and that is formed on the superjunction structure layer;
a collector layer formed on a second principal surface of the N-type buffer layer, wherein the collector layer comprises P+ collectors and N+ collectors, and the P+ collectors and the N+ collectors are alternately arranged in the first direction; and
a collector electrode layer formed on the collector layer, wherein
in the superjunction structure layer, a region portion corresponding to the N+ collectors forms a first region and a region portion corresponding to the P+ collectors forms a second region, and in the second direction, a length of each drift region in the first region is not equal to a length of each drift region in the second region.

2. The superjunction reverse conducting insulated gate bipolar transistor according to claim 1, wherein the front-side component comprises:
an N-drift layer formed on the superjunction structure layer;
a P-base layer formed on the N-drift layer;
N-type emitter layers and P+ contact layers that are formed on a surface of the P-base layer, wherein the N-type emitter layers and the P+ contact layers are alternately arranged in the first direction;
a gate electrode penetrating from surfaces of the N-type emitter layers to the N-drift layer, wherein a gate oxide layer is formed on a surface layer of the gate electrode; and
an emitter electrode formed on the N-type emitter layers, wherein the emitter electrode is electrically connected to the N-type emitter layers, and the emitter electrode is insulated from the gate electrode.

3. The superjunction reverse conducting insulated gate bipolar transistor according to claim 2, wherein in the second direction, a thickness of the superjunction structure layer in the first region is not equal to a thickness of the superjunction structure layer in the second region, drift regions in the first region are continuous in the second direction, and drift regions in the second region are continuous in the second direction.

4. The superjunction reverse conducting insulated gate bipolar transistor according to claim 2, wherein in the second direction, a thickness of the superjunction structure layer in the first region is equal to a thickness of the superjunction structure layer in the second region, drift regions in the first region are discontinuous in the second direction, and/or drift regions in the second region are discontinuous in the second direction.

5. The superjunction reverse conducting insulated gate bipolar transistor according to claim 4, wherein in the first region or the second region, each drift region has a segmented region in the second direction, and the segmented regions of the drift regions are continuous in the first direction.

6. The superjunction reverse conducting insulated gate bipolar transistor according to claim 4, wherein in the first region or the second region, each drift region has a segmented region in the second direction, and the segmented regions of the drift regions are discontinuous in the first direction.

7. The superjunction reverse conducting insulated gate bipolar transistor according to claim 4, wherein in the first region and the second region, each drift region has a segmented region in the second direction, and in the second direction, a length of the segmented region of each drift region in the first region is not equal to a length of the segmented region of each drift region in the second region.

8. The superjunction reverse conducting insulated gate bipolar transistor according to claim 7, wherein the segmented regions of the drift regions in the first region are continuous in the first direction, and the segmented regions of the drift regions in the second region are continuous in the first direction; or
the segmented regions of the drift regions in the first region are discontinuous in the first direction, and the segmented regions of the drift regions in the second region are discontinuous in the first direction; or
the segmented regions of the drift regions in the first region are continuous in the first direction, and the segmented regions of the drift regions in the second region are discontinuous in the first direction; or
the segmented regions of the drift regions in the first region are discontinuous in the first direction, and the segmented regions of the drift regions in the second region are continuous in the first direction.

9. The superjunction reverse conducting insulated gate bipolar transistor according to any one of claims 2 to 8, wherein the superjunction structure layer is electrically connected to the emitter electrode in the first region; or
the superjunction structure layer is electrically connected to the emitter electrode in the second region; or
the superjunction structure layer is electrically connected to the emitter electrode in the first region, and the superjunction structure layer is electrically connected to the emitter electrode in the second region.

10. An electric automobile motor control unit, comprising the superjunction reverse conducting insulated gate bipolar transistor according to any one of claims 1 to 9.
